# EUROPEAN PATENT APPLICATION

(11) **EP 3 998 628 A1**
(43) Date of publication of application: **18.05.2022**
(21) Application number: 21773276.7
(22) Date of filing: 15.06.2021
(51) Int. Cl.: H01L 23/488, H01L 21/60

(54) **SOLDER PAD STRUCTURE, SEMICONDUCTOR STRUCTURE, SEMICONDUCTOR PACKAGING STRUCTURE, AND PREPARATION METHOD THEREFOR**

(30) Priority: 17.09.2020 CN 202010979526
(71) Applicant: Changxin Memory Technologies, Inc., Hefei City, Anhui 230000 (CN)
(72) Inventor: WU, Ping-heng, Hefei City Anhui 230000 (CN)
(74) Representative: V.O.
(86) International application number: PCT/CN2021/100185
(87) International publication number: WO 2022/057339

(57) **Abstract**

Provided are a bonding pad structure, a semiconductor structure, a semiconductor package structure and a method for preparing the same, which relate to the technical field of semiconductor package and are configured to solve the technical problem that separation easily occurred between adjacent semiconductors during bonding due to thermal expansion, and accordingly package quality of a semiconductor device is affected. For the bonding pad structure, the semiconductor structure and the semiconductor package structure provided by the examples, an expansion stagnating block (20) subjected to high-temperature tempering treatment is partially wrapped inside a bonding pad layer (10), the expansion stagnating block 20 subjected to the high-temperature tempering will not subjected to expansion or will have a small expansion during bonding of two semiconductor units. Moreover, the expansion stagnating block 20 extends into the bonding pad layer (10) and can reduce part of a volume of the bonding pad layer (10), in this way an expansion volume of the bonding pad layer (10) is reduced during bonding, and accordingly drive force driving two adjacent semiconductor units to separate is reduced, thereby avoiding the separation between the two adjacent semiconductor units during bonding.

## Description

### CROSS-REFERENCE TO RELATED APPLICATION

This application claims priority to the Chinese Patent Application No. 202010979526.4, filed to the China National Intellectual Property Administration on September 17, 2020, entitled "BONDING PAD STRUCTURE, SEMICONDUCTOR STRUCTURE, SEMICONDUCTOR PACKAGE STRUCTURE AND METHOD FOR PREPARING SAME", which is incorporated by reference herein in its entirety.

### TECHNICAL FIELD

The application relates to the technical field of semiconductor package, and in particular to a bonding pad structure, a semiconductor structure, a semiconductor package structure and a method for preparing the same.

### BACKGROUND

With the development of an integrated circuit technology, it has become a research hotspot to form a semiconductor device with high performance by stacking multiple semiconductor units (such as wafers or chips) and bonding two adjacent semiconductor units, specifically such as two adjacent wafers or two adjacent chips.

In the related art, a semiconductor device has a first semiconductor unit and a second semiconductor unit that are adjacent to each other, and a bonding pad is arranged in each of dielectric layers which are face to face. However, during a bonding process, thermal expansion may easily cause separation of the first semiconductor unit from the second semiconductor unit, and accordingly package quality of the semiconductor device is affected.

### SUMMARY

In view of this, the disclosure provides a bonding pad structure, a semiconductor structure, a semiconductor package structure and a method for preparing the same, so as to solve the technical problem that semiconductor units are easily separated during a bonding process.

The disclosure provides a bonding pad structure. It includes a bonding pad layer and an expansion stagnating block that is at least wrapped by the bonding pad layer partially. The expansion stagnating block is subjected to high-temperature tempering treatment.

For the abovementioned bonding pad structure, an isolation layer is arranged between the bonding pad layer and the expansion stagnating block.

For the abovementioned bonding pad structure, the bonding pad layer includes a bonding pad top layer and a bonding pad bottom layer that are arranged in a stacked manner, the bonding pad top layer is arranged on a side of a bonding pad close to a bonding surface, the bonding pad bottom layer and the bonding pad top layer are integrated as a whole, and projection of the bonding pad bottom layer on the bonding surface is positioned in projection of the bonding pad top layer on the bonding surface.

The disclosure further provides a semiconductor package structure. It includes a semiconductor substrate. The semiconductor substrate is provided with the abovementioned bonding pad structure.

The disclosure further provides a semiconductor structure. It includes a bonding pad layer and an expansion stagnating block. The expansion stagnating block extends into the bonding pad layer, and the expansion stagnating block is subjected to high-temperature tempering treatment.

For the abovementioned semiconductor structure, an isolation layer is arranged between the bonding pad layer and the expansion stagnating block.

For the abovementioned semiconductor structure, the bonding pad layer includes a bonding pad top layer and a bonding pad bottom layer that are arranged in a stacked manner, the bonding pad top layer is arranged on a side of the bonding pad layer close to a bonding surface, the bonding pad bottom layer and the bonding pad top layer are integrated as a whole, and projection of the bonding pad bottom layer on the bonding surface is positioned in projection of the bonding pad top layer on the bonding surface.

The disclosure further provides a semiconductor package structure. It includes a semiconductor substrate. The semiconductor substrate is provided with the abovementioned semiconductor structure.

The disclosure further provides a method for preparing a semiconductor package structure. The method includes the following operations. A semiconductor substrate having an expansion stagnating block subjected to high-temperature tempering treatment therein is formed. A bonding pad groove is formed on a bonding surface of the semiconductor substrate to expose part of the expansion stagnating block. A bonding pad layer is formed in the bonding pad groove.

For the abovementioned method for preparing the semiconductor package structure, after the operation that the bonding pad groove is formed on the bonding surface of the semiconductor substrate, the method further includes: an isolation layer is formed on a bottom of the bonding pad groove and the expansion stagnating block, respectively.

For the abovementioned method for preparing the semiconductor package structure, the operation that the bonding pad groove is formed includes: a bonding pad bottom layer notch is formed on the bonding surface of the semiconductor substrate to expose part of the expansion stagnating block; part of a side wall of an end of the bonding pad bottom layer notch far away from a bottom of the bonding pad groove is removed to form a bonding pad top layer notch; and the bonding pad bottom layer notch is filled with a bonding pad bottom layer, and the bonding pad top layer notch is filled with a bonding pad top layer that is integrally arranged with the bonding pad bottom layer.

For the abovementioned method for preparing the semiconductor package structure, after the operation that the bonding pad layer is formed in the bonding pad groove, the method further includes: a recess is formed on a surface of the bonding pad layer facing the bonding surface.

For the bonding pad structure, the semiconductor structure, the semiconductor package structure and the method preparing the same provided by the disclosure, the expansion stagnating block is partially wrapped by the bonding pad layer, the expansion stagnating block extends into the bonding pad layer, the expansion stagnating block is subjected to the high-temperature tempering treatment, and the expansion stagnating block subjected to the high-temperature tempering treatment will not expand or will have a small expansion during bonding. Moreover, the expansion stagnating block extends into the bonding pad layer and can replace part of a volume of the bonding pad layer, in this way an expansion volume of the bonding pad layer is reduced during the bonding process, and accordingly drive force driving two adjacent semiconductor units to separate is reduced, and separation of the two adjacent semiconductor units is avoided during the bonding process.

### BRIEF DESCRIPTION OF THE DRAWINGS

In order to describe the technical solutions of the examples of the application more clearly, the drawings required to be used in the examples will be simply introduced below. It is apparent that the drawings described below are only some examples of the application. Other drawings may further be obtained by those of ordinary skill in the art according to these drawings without creative work.
FIG. 1 is a structure diagram 1 of a bonding pad structure provided by an example of the application.
FIG. 2 is a structure diagram 2 of a bonding pad structure provided by an example of the application.
FIG. 3 is a structure diagram 3 of a bonding pad structure provided by an example of the application.
FIG. 4 is a structure diagram 1 of a semiconductor package structure provided by an example of the application.
FIG. 5 is a structure diagram 1 of a semiconductor structure provided by an example of the application.
FIG. 6 is a structure diagram 2 of a semiconductor structure provided by an example of the application.
FIG. 7 is a structure diagram 3 of a semiconductor structure provided by an example of the application.
FIG. 8 is a structure diagram 2 of a semiconductor package structure provided by an example of the application.
FIG. 9 is a connecting diagram 1 of a semiconductor package structure provided by an example of the application.
FIG. 10 is a flow chart of a method for preparing a semiconductor package structure provided by an example of the application.
FIG. 11 is a diagram of forming a substrate layer in a method for preparing a semiconductor package structure provided by an example of the application, in the substrate layer, there is an expansion stagnating block subjected to high-temperature tempering treatment.
FIG. 12 is a diagram of thinning a substrate layer to make part of an expansion stagnating block protrude out of a surface of the substrate layer in a method for preparing a semiconductor package structure provided by an example of the application.
FIG. 13 is a diagram of forming a dielectric layer and a dielectric surface layer on a surface having an expansion stagnating block in a method for preparing a semiconductor package structure provided by an example of the application.
FIG. 14 is a diagram of forming a bonding pad groove on a dielectric surface layer in a method for preparing a semiconductor package structure provided by an example of the application.
FIG. 15 is a diagram of forming a bonding pad bottom layer notch on a dielectric surface layer in a method for preparing a semiconductor package structure provided by an example of the application.
FIG. 16 is a diagram of forming a bonding pad top layer notch in a method for preparing a semiconductor package structure provided by an example of the application.
FIG. 17 is a diagram 1 of forming an isolation layer in a method for preparing a semiconductor package structure provided by an example of the application.
FIG. 18 is a diagram 2 of forming an isolation layer in a method for preparing a semiconductor package structure provided by an example of the application.
FIG. 19 is a diagram of forming a bonding pad layer in a bonding pad groove in a method for preparing a semiconductor package structure provided by an example of the application.
FIG. 20 is a diagram of forming a bonding pad bottom layer and a bonding pad top layer in a bonding pad groove in a method for preparing a semiconductor package structure provided by an example of the application.
FIG. 21 is a step diagram 1 of stacking multiple semiconductor units in a method for preparing a semiconductor package structure provided by an example of the application.
FIG. 22 is a step diagram 2 of stacking multiple semiconductor units in a method for preparing a semiconductor package structure provided by an example of the application.
FIG. 23 is a step diagram 3 of stacking multiple semiconductor units in a method for preparing a semiconductor package structure provided by an example of the application.
FIG. 24 is a step diagram 4 of stacking multiple semiconductor units in a method for preparing a semiconductor package structure provided by an example of the application.
FIG. 25 is a step diagram 5 of stacking multiple semiconductor units in a method for preparing a semiconductor package structure provided by an example of the application.
FIG. 26 is a step diagram 6 of stacking multiple semiconductor units in a method for preparing a semiconductor package structure provided by an example of the application.
FIG. 27 is a step diagram 7 of stacking multiple semiconductor units in a method for preparing a semiconductor package structure provided by an example of the application.
FIG. 28 is a step diagram 8 of stacking multiple semiconductor units in a method for preparing a semiconductor package structure provided by an example of the application.
FIG. 29 is a step diagram 9 of stacking multiple semiconductor units in a method for preparing a semiconductor package structure provided by an example of the application.

The abovementioned drawings may include the following reference numbers:

10: Bonding pad layer; 20: Expansion stagnating block; 30: Isolation layer; 40: Semiconductor substrate; 50: Dielectric coating layer; 60: Bonding pad groove; 70: Recess; 80: Adhesion layer; 90: Transfer block; 100: Base layer; 101: Bonding pad top layer; 102: Bonding pad bottom layer; 401: Substrate layer; 402: Dielectric layer; 403: Dielectric surface layer; 601: Bonding pad top layer notch; 602: Bonding pad bottom layer notch.

### DETAILED DESCRIPTION

In order to make an objective, the technical solutions and advantages of the disclosure clearer, the technical solutions in the disclosure will be clearly and completely described below in combination with the drawings in the disclosure. It is apparent that the described examples are not all examples but part of examples of the disclosure. All other examples obtained by those of ordinary skill in the art on the basis of the examples in the application without creative work shall fall within the scope of protection of the disclosure.

In the disclosure, unless otherwise definitely specified, terms "mount", "link", "connect", "fix" and the like should be broadly understood. For example, the terms may refer to fixed connection, detachable connection or integration. The terms may refer to mechanical connection, electrical connection or mutual communication. The terms may refer to direct link; they may also refer to indirect connection through a medium and may refer to communication in two components or an interaction relationship of the two components, unless otherwise definitely limited. For those of ordinary skill in the art, specific meanings of these terms in the disclosure can be understood according to a specific condition.

A semiconductor device includes a first semiconductor unit and a second semiconductor unit that are arranged in a stacked manner, and the semiconductor unit includes a bonding pad. When bonding is required, the bonding pads are subjected to high-temperature treatment correspondingly, in this way the bonding pads are bonded. More specifically, when a side of the first semiconductor unit facing the second semiconductor unit is a first dielectric layer, the first dielectric layer is provided with a first bonding pad therein. Similarly, when a side of the second semiconductor unit facing the first semiconductor unit is a second dielectric layer, the second dielectric layer is provided with a second bonding pad therein. During a bonding process, it is ideal that the first dielectric layer is in connection with the second dielectric layer, and the first bonding pad is in connection with the second dielectric layer. The process is specifically implemented as follows: the dielectric layer is subjected to low-temperature tempering fusion bonding first, and the first bonding pad and the second bonding pad are subjected to hybrid bonding through high-temperature tempering, then electric connection is realized between the first bonding pad and the second bonding pad, in this way signaling can be implemented between the first semiconductor unit and the second semiconductor unit. However, a bonding pad structure in a single semiconductor unit may easily cause expansion of metal in a bonding pad layer out of an original bonding pad surface when subjected to thermal expansion. In a current or subsequent thermal process, the bonding pad layer may expand as well, and then a bonding contact surface connecting the first semiconductor unit with the second semiconductor unit may be propped out, thereby causing separation of the semiconductor units from each other. In addition, when metal pads of the two semiconductor units are poorly aligned, an area of the bonding contact surface of the two will be decreased as well, and it is more likely to cause separation of the bonding contact surface in the subsequent thermal process, and accordingly delamination may occur.

The disclosure provides a bonding pad structure. An expansion stagnating block subjected to high-temperature tempering is arranged in a bonding pad layer to reduce a volume of the bonding pad layer. During a bonding process of semiconductor units, an expansion of a corresponding bonding pad layer is reduced because the volume of the bonding pad layer is reduced, and the bonding pad layer will not expand any longer when heated again because the expansion stagnating block has been subjected to the high-temperature tempering. Thus, the separation between the two adjacent semiconductor units may be effectively avoided in subsequent thermal treatment.

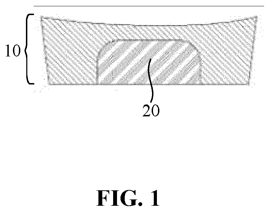

As shown in FIG. 1, the bonding pad structure provided by the example includes a bonding pad layer 10 and an expansion stagnating block 20 that is at least wrapped by the bonding pad layer 10 partially. A position of arranging the bonding pad layer 10 is not limited in the example, and the bonding pad layer 10 may be arranged on a wafer or on a chip as well. The expansion stagnating block 20 is at least wrapped by the bonding pad layer 10 partially. The expansion stagnating block 20 is positioned at a side of the bonding pad layer 10 far away from a bonding surface. Exemplarily, the expansion stagnating block 20 may be positioned at a center of the side of the bonding pad layer 10 far away from the bonding surface, or positioned on an edge of the side of the bonding pad layer 10 far away from the bonding surface as well, and may reach out from the bonding pad layer 10, or positioned in the bonding pad layer 10 as well. The only requirement is that the expansion stagnating block 20 occupies part of the volume of the bonding pad layer 10, and a volume of an expanded bonding pad is decreased during the subsequent thermal treatment process.

Exemplarily, an area of an end of the bonding pad layer 10 close to the bonding surface is greater than an area of an end of the bonding pad layer 10 far away from the bonding surface, in this way a contact area of a bonding pad during bonding is increased; matching accuracy required for two semiconductor units is lowered. An allowable docking error when docking the bonding pad is increased to some extent, thereby reducing the difficulty of manufacturing the semiconductor unit.

The bonding pad layer 10 may be copper, silver, gold, aluminum and other metal blocks, and is not limited in the example.

The expansion stagnating block 20 is subjected to the high-temperature tempering treatment. In the example, the expansion stagnating block 20 may be the metal block or other nonmetallic block, and the expansion stagnating block 20 will not subjected to expansion or will have a small expansion during the bonding process of two adjacent semiconductor units as long as the expansion stagnating block 20 has been subjected to the high-temperature tempering treatment. In a case that the expansion stagnating block 20 is a metal block, the expansion stagnating block 20 may be formed through a Through Silicon Via (TSV) process. A material of the expansion stagnating block 20 may be copper or tungsten; of course, it may be other related integrated circuit materials as well, and is not limited to the example.

The bonding pad layer 10 in the bonding pad structure has the expansion stagnating block 20 subjected to the high-temperature tempering treatment, the expansion stagnating block 20 that is partially wrapped by the bonding pad layer 10 has been subjected to the high-temperature tempering treatment, thus the expansion stagnating block 20 that has been tempered at high temperature will not expand or will have the small expansion during the bonding process of the two semiconductor units. Moreover, the expansion stagnating block 20 reduces the volume of the bonding pad layer 10, in this way an expansion volume of the bonding pad layer 10 is reduced during the bonding process of the two semiconductor units, and accordingly drive force driving the semiconductor units to separate is reduced, and separation between the semiconductor units is avoided.

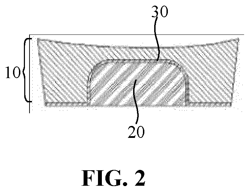

Further, as shown in FIG. 2, an isolation layer 30 is arranged between the bonding pad layer 10 and the expansion stagnating block 20. In the example, a material of the isolation layer 30 may include tantalum, tantalum oxide and the like.

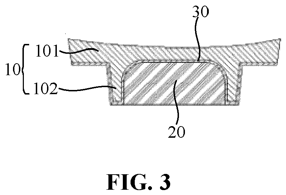

Further, as shown in FIG. 3, in a mode of implementation that the expansion stagnating block 20 is a metal block and the isolation layer 30 is arranged between the bonding pad layer 10 and the expansion stagnating block 20, the bonding pad layer 10 includes a bonding pad top layer 101 and a bonding pad bottom layer 102 that are arranged in a stacked manner. Exemplarily, projection of the bonding pad top layer 101 on the bonding surface may be circular; of course, the projection of the bonding pad top layer 101 on the bonding surface may be rectangular, triangular or in other shapes as well. Similarly, projection of the bonding pad bottom layer 102 on the bonding surface may be circular; of course, the projection of the bonding pad bottom layer 102 on the bonding surface may be rectangular, triangular or in other shapes as well. The bonding pad top layer 101 is arranged on a side of the bonding pad close to the bonding surface, the bonding pad bottom layer 102 is arranged on a side of the bonding pad far away from the bonding surface, and the bonding pad bottom layer 102 and the bonding pad top layer 101 are integrated as a whole. The projection of the bonding pad bottom layer 102 on the bonding surface is positioned in the projection of the bonding pad top layer 101 on the bonding surface, that is to say, in sections parallel to the bonding surface, a section area of the bonding pad bottom layer 102 is smaller than a section area of the bonding pad top layer 101. In this way, in a case that the expansion stagnating block 20 reduces the volume of the bonding pad layer 10, a thickness of an edge of the bonding pad layer 10 is further thinned, thereby reducing an expansion of a metal in an edge area in which the bonding pad is easily separated, and further lowering a risk of separation between the two semiconductor units.

In a mode of implementation, the expansion stagnating block 20 extends into the bonding pad bottom layer 102; it extends into the bonding pad top layer 101 from an end of the bonding pad bottom layer 102 far away from the bonding pad top layer 101 and towards the bonding pad top layer 101. Of course, an extension depth of the expansion stagnating block 20 into the bonding pad bottom layer 102 may be increased, in this way the expansion stagnating block 20 goes through the bonding pad bottom layer 102 and extends into the bonding pad top layer 101.

The disclosure further provides a semiconductor package structure. The semiconductor package structure includes a semiconductor substrate, the semiconductor substrate being provided with the bonding pad structure provided in the abovementioned examples. For the semiconductor package structure provided by the example, a bonding pad layer is provided with an expansion stagnating block subjected to high-temperature tempering therein to reduce a volume of the bonding pad layer. During a bonding process of semiconductor units, an expansion of a corresponding bonding pad layer is reduced because the volume of the bonding pad layer is reduced, thereby avoiding the separation between two adjacent semiconductor units.

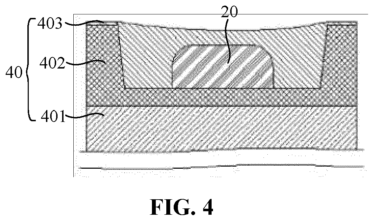

As shown in FIG. 4, the semiconductor package structure provided by the example includes a semiconductor substrate 40; the semiconductor substrate 40 includes a substrate layer 401 far away from a bonding surface. A material of the substrate layer 401 may include one or more of silicon, silicon germanium and germanium. The semiconductor substrate 40 further includes a dielectric layer 402 and a dielectric surface layer 403 that are arranged sequentially on the substrate layer 401. Materials of the dielectric layer 402 and the dielectric surface layer 403 may include one or more of silicon dioxide, silicon nitride, silicon oxynitride, silicon carbide, silicon oxycarbide, silicon carbidnitride, and other semiconductor-related dielectric materials, and are not limited to the example. The semiconductor substrate 40 is provided with the bonding pad structure. The semiconductor substrate 40 may be provided with the bonding pad structure as shown in FIG. 1. Of course, the semiconductor substrate 40 may also be provided with the bonding pad structure as shown in FIG. 2 or FIG. 3.

The bonding pad structure is arranged at the dielectric surface layer 403 and extends into the dielectric layer 402. In a mode of implementation that the bonding pad layer 10 includes a bonding pad top layer 101 and a bonding pad bottom layer 102 that are arranged in a stacked manner, a bonding pad surface layer is arranged at the dielectric surface layer 403 and extends into the dielectric layer 402, and the bonding pad bottom layer 102 is arranged at a side of the bonding pad surface layer far away from the dielectric surface layer 403.

The example further provides a semiconductor structure. An expansion stagnating block extending into a bonding pad layer and subjected to high-temperature tempering reduces a volume of the bonding pad layer. During a bonding process of semiconductor units, an expansion of a corresponding bonding pad layer is reduced because the volume of the bonding pad layer is reduced, thereby avoiding the separation between two adjacent semiconductor units.

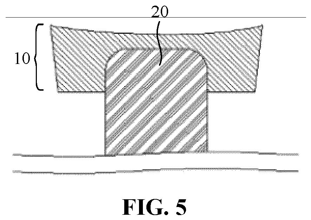

As shown in FIG. 5, the semiconductor structure provided by the example includes the bonding pad layer 10 and the expansion stagnating block 20, and the bonding pad layer 10 is not limited in the example. The bonding pad layer 10 may be arranged on a wafer, or on a chip. The expansion stagnating block 20 extends into the bonding pad layer 10, and the expansion stagnating block 20 extends into the bonding pad layer 10 from a side of the bonding pad layer 10 far away from a bonding surface. Exemplarily, the expansion stagnating block 20 may extend into the bonding pad layer 10 from a center of the side of the bonding pad layer 10 far away from the bonding surface; also it may extend into the bonding pad layer 10 from other positions and even an edge of the side of the bonding pad layer 10 far away from the bonding surface. The only requirement is that the expansion stagnating block 20 occupies part of a volume of the bonding pad layer 10, and a volume of an expanded bonding pad is decreased during subsequent thermal treatment.
Exemplarily, an area of an end of the bonding pad layer 10 close to the bonding surface is greater than an area of an end of the bonding pad layer 10 far away from the bonding surface, in this way a contact area of a bonding pad during bonding is increased; matching accuracy required for two semiconductor units is lowered. An allowable docking error when docking the bonding pad is increased to some extent, thereby reducing the difficulty of manufacturing the semiconductor unit.

The bonding pad layer 10 may be copper, silver, gold, aluminum and other metal blocks, and is not limited in the example.

The expansion stagnating block 20 is subjected to the high-temperature tempering treatment. In the example, the expansion stagnating block 20 may be the metal block or other nonmetallic block, and the expansion stagnating block 20 will not expand or will have a small expansion during a bonding process of two adjacent semiconductor units as long as the expansion stagnating block 20 has been subjected to the high-temperature tempering treatment. In a case that the expansion stagnating block 20 is a metal block, the expansion stagnating block 20 may be formed through a TSV process. A material of the expansion stagnating block 20 may be copper or tungsten; of course, it may be other related integrated circuit materials as well, and is not limited to the example.

An expansion stagnating block 20 subjected to the high-temperature tempering treatment is extending in the bonding pad layer 10 in the bonding pad structure. The expansion stagnating block 20 has been subjected to the high-temperature tempering treatment, thus the expansion stagnating block 20 subjected to the high-temperature tempering will not expand or will have a small expansion during bonding the two semiconductor units. Moreover, the expansion stagnating block 20 reduces the volume of the bonding pad layer 10, in this way an expansion volume of the bonding pad layer 10 is reduced during the bonding process of the two semiconductor units, and accordingly drive force driving the semiconductor units to separate is reduced, and the separation between the semiconductor units is avoided.

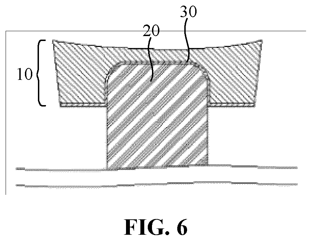

Further, as shown in FIG. 6, an isolation layer 30 is arranged between the bonding pad layer 10 and the expansion stagnating block 20. In the example, a material of the isolation layer 30 may include tantalum, tantalum oxide and other materials.

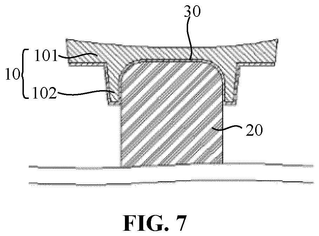

Further, as shown in FIG. 7, in a mode of implementation that the isolation layer 30 is arranged between the bonding pad layer 10 and the expansion stagnating block 20 which is a metal block, the bonding pad layer 10 includes a bonding pad top layer 101 and a bonding pad bottom layer 102 that are arranged in a stacked manner. Exemplarily, projection of the bonding pad top layer 101 on the bonding surface may be circular; of course, the projection of the bonding pad top layer 101 on the bonding surface may be rectangular, triangular or in other shapes as well. Similarly, projection of the bonding pad bottom layer 102 on the bonding surface may be circular; of course, the projection of the bonding pad bottom layer 102 on the bonding surface may be rectangular, triangular or in other shapes as well. The bonding pad top layer 101 is arranged on a side of the bonding pad close to the bonding surface, the bonding pad bottom layer 102 is arranged on a side of the bonding pad far away from the bonding surface, and the bonding pad bottom layer 102 and the bonding pad top layer 101 are integrated as a whole. The projection of the bonding pad bottom layer 102 on the bonding surface is positioned in the projection of the bonding pad top layer 101 on the bonding surface, that is to say, in sections parallel to the bonding surface, a section area of the bonding pad bottom layer 102 is smaller than a section area of the bonding pad top layer 101. In this way, in a case that the expansion stagnating block reduces the volume of the bonding pad layer 10, a thickness of an edge of the bonding pad layer 10 is further thinned, thereby reducing an expansion of a metal in an edge area in which the bonding pad is easily separated, and further lowering a risk of separation between two semiconductor units. In a mode of implementation, the expansion stagnating block 20 extends into the bonding pad bottom layer 102, and extends from an end of the bonding pad bottom layer 102 far away from the bonding pad top layer 101 and towards the bonding pad top layer 101. Of course, an extension depth of the expansion stagnating block 20 into the bonding pad bottom layer 102 may be increased, in this way the expansion stagnating block 20 goes through the bonding pad bottom layer 102 and extends into the bonding pad top layer 101.

The example further provides a semiconductor package structure. The semiconductor package structure includes a semiconductor substrate, the semiconductor substrate being provided with the semiconductor structure provided in the abovementioned examples. For the semiconductor package structure provided by the example, by using an expansion stagnating block that extends into a bonding pad layer and has been subjected to high-temperature tempering, a volume of the bonding pad layer is reduced. During a bonding process of semiconductor units, an expansion of a corresponding bonding pad layer is reduced because the volume of the bonding pad layer is reduced, thereby avoiding the separation between two adjacent semiconductor units.

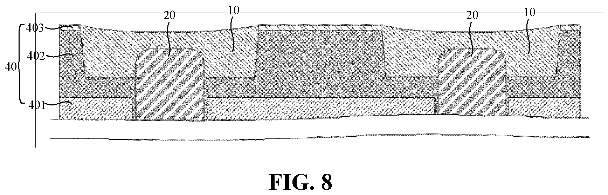

As shown in FIG. 8, the semiconductor package structure provided by the example includes a semiconductor substrate 40; the semiconductor substrate 40 includes a substrate layer 401 far away from a bonding surface. A material of the substrate layer 401 may include one or more of silicon, silicon germanium and germanium. The semiconductor substrate 40 further includes a dielectric layer 402 and a dielectric surface layer 403 that are arranged sequentially on the substrate layer 401. Materials of the dielectric layer 402 and the dielectric surface layer 403 may include one or more of silicon dioxide, silicon nitride, silicon oxynitride, silicon carbide, silicon oxycarbide, silicon carbidenitride, and other semiconductor-related dielectric materials, and are not limited to the example. The semiconductor substrate 40 is provided with the semiconductor structure. The semiconductor substrate 40 may be provided with the semiconductor structure as shown in FIG. 5. Of course, the semiconductor substrate 40 may be provided with the semiconductor structure as shown in FIG. 6 or FIG. 7 as well.

The bonding pad layer 10 in the semiconductor structure is arranged at the dielectric surface layer 403 and extends into the dielectric layer 402, and the expansion stagnating block 20 in the semiconductor structure extends into the bonding pad layer 10 from the substrate layer 401. In a mode of implementation that the bonding pad layer 10 includes a bonding pad top layer 101 and a bonding pad bottom layer 102 that are arranged in a stacked manner, a bonding pad surface layer is arranged at the dielectric surface layer 403 and extends into the dielectric layer 402, and the bonding pad bottom layer 102 is arranged on a side of the bonding pad surface layer far away from the dielectric surface layer 403.

A semiconductor device may include multiple semiconductor units that are arranged in a stacked manner, two adjacent semiconductor units are electrically connected with each other to realize signal transmission between all semiconductor units. It is noted that the semiconductor package structure in the example may be a structure arranged at any semiconductor unit and for use on a connecting surface with other semiconductor units in the semiconductor device.

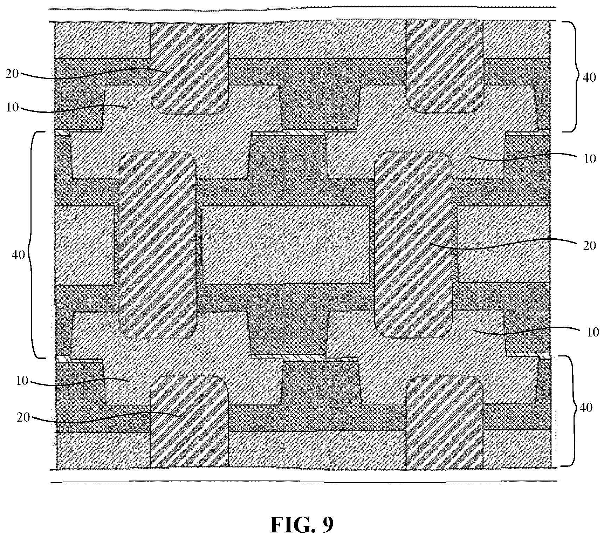

Further, as shown in FIG. 9, in a mode of implementation that the semiconductor substrate 40 is provided with the semiconductor structure as shown in FIG. 5, the semiconductor package structure may be arranged at two sides of the semiconductor unit along a stacked direction, namely, two surfaces of the semiconductor unit along with the stacked direction are provided with the bonding pad layer 10, correspondingly, one end of the expansion stagnating block 20 reaches out from a bonding pad layer 10 on one surface and extends into corresponding bonding pad layer 10, and another end of the expansion stagnating block 20 reaches out from another bonding pad layer 10 on another surface and extends into corresponding another bonding pad layer 10. In this way, the bonding pad layers 10 positioned on different surfaces of the semiconductor unit may be connected through the expansion stagnating block 20. In addition, the bonding pad layers 10 of two surfaces of the semiconductor units share part of stagnant expansion blocks 20, separation of the semiconductor units from adjacent semiconductor units can be avoided.

The example of the application further provides a method for preparing a semiconductor package structure. The method can be applied to manufacturing of the semiconductor package structure provided by the abovementioned examples. For the semiconductor package structure manufactured with the method, a semiconductor substrate is provided with a bonding pad layer and an expansion stagnating block, the expansion stagnating block extends into the bonding pad layer, and the expansion stagnating block is subjected to high-temperature tempering treatment. The expansion stagnating block subjected to the high-temperature tempering will not expand or will have a small expansion during bonding. Moreover, the expansion stagnating block extends into the bonding pad layer and can reduce a volume of the bonding pad layer, in this way an expansion volume of the bonding pad layer is reduced during the bonding process, and accordingly drive force driving the two adjacent semiconductor units to separate is reduced, thereby avoiding the separation between the semiconductor units.

In the semiconductor package structure, the semiconductor substrate is provided with one or more abovementioned semiconductor structures. In the method for preparing the semiconductor package structure provided by the example of the application and the drawings, the semiconductor substrate provided with two abovementioned semiconductor structures is taken as an example to illustrate, number of the semiconductor structures should not be understood as limitation to the example.

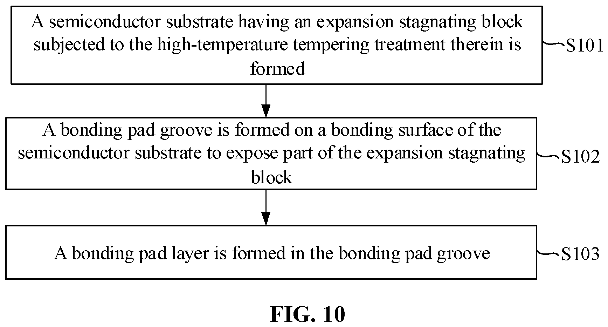

As shown in FIG. 10, the method for preparing the semiconductor package structure provided by the example may include the following operations.

At S101, a semiconductor substrate is formed, the semiconductor substrate having a stagnant expansion block subjected to high-temperature tempering treatment therein.

The semiconductor substrate 40 is not limited in the example. Exemplarily, the semiconductor substrate 40 may be a chip; the semiconductor substrate 40 may be a wafer as well.

In a mode of implementation that the semiconductor substrate 40 is a wafer, the operation that the semiconductor substrate 40 is formed, the semiconductor substrate 40 having the expansion stagnating block 20 subjected to high-temperature tempering treatment therein includes the following operations.

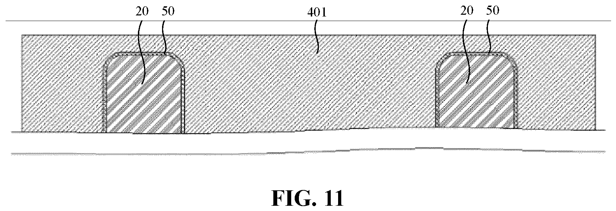

As shown in FIG. 11, a substrate layer 401 is formed, the substrate layer 401 having the expansion stagnating block subjected to high-temperature tempering therein. The substrate layer 401 may include one or more of silicon, silicon germanium and germanium, the expansion stagnating block 20 may be a metal block or other nonmetallic block. In a case that the expansion stagnating block 20 is a metal block, the expansion stagnating block 20 may be formed through a TSV process, and a material of the expansion stagnating block 20 may be copper or tungsten, and the like. Of course, the material of the expansion stagnating block 20 may be other related integrated circuit materials as well, and is not limited to the example. A surface of the expansion stagnating block 20 formed in the substrate layer 401 through the TSV process may be coated with a layer of dielectric coating layer 50.

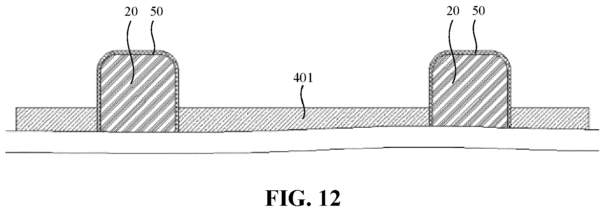

As shown in FIG. 12, the substrate layer 401 is thinned, in this way part of the expansion stagnating block 20 protrudes out of a surface of the substrate layer 401. At the moment, the surface of the expansion stagnating block 20 may be still coated with one layer of dielectric coating layer 50. The operation that the substrate layer 401 is thinned may be realized through photoetching, dry etching, wet etching and other methods.

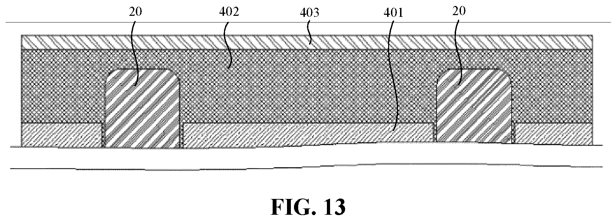

As shown in FIG. 13, a dielectric layer 402 is formed on the surface of the expansion stagnating block 20, and the expansion stagnating block 20 is wrapped by the dielectric layer 402. At the moment, a dielectric coating layer 50 possibly coated on the surface of the expansion stagnating block 20 is integrated with the formed dielectric layer 402 as a whole. The dielectric layer 402 may be formed through deposition and other methods. A surface of the dielectric layer 402 is planarized, and a dielectric surface layer 403 is formed on the dielectric layer 402 to repair the surface. The dielectric surface layer 403 may be formed through deposition and other methods, and materials of the dielectric layer 402 and the dielectric surface layer 403 may include one or more of silicon dioxide, silicon nitride, silicon oxynitride, silicon carbide, silicon oxycarbide, silicon carbidenitride, and other semiconductor-related dielectric materials, and are not limited to the example.

Referring to FIG. 10 continuously, the method for preparing the semiconductor package structure provided by the example further includes the following operations.

At S102, a bonding pad groove is formed on a bonding surface of the semiconductor substrate, to expose part of the expansion stagnating block.

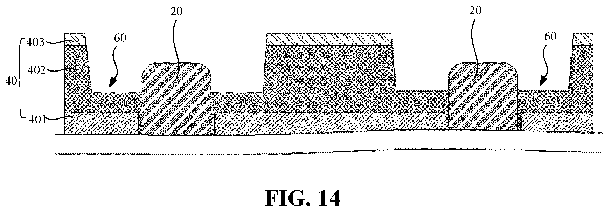

As shown in FIG. 14, the bonding pad groove 60 is formed on the dielectric surface layer 403; the bonding pad groove 60 extends to the dielectric layer 402, so as to expose part of the expansion stagnating block 20. The bonding pad groove 60 may be formed through photoetching, dry etching, wet etching and other methods. At the moment, the dielectric coating layer 50 possibly coated on the surface of the expansion stagnating block 20 is removed while forming the bonding pad groove 60, in this way the expansion stagnating block 20 is exposed in the bonding pad groove 60.

Further, the operation that the bonding pad groove 60 is formed includes the following operations.

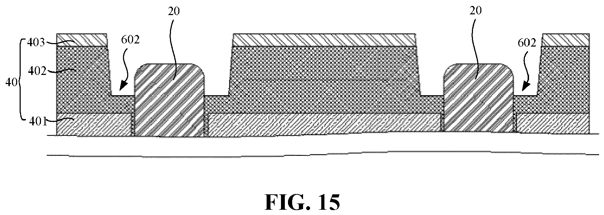

As shown in FIG. 15, a bonding pad bottom layer notch 602 is formed on the bonding surface of the semiconductor substrate 40, namely, the dielectric surface layer 403 to expose part of the expansion stagnating block 20. The bonding pad bottom layer notch 602 may be formed through photoetching, dry etching, wet etching and other methods. At the moment, the dielectric coating layer 50 possibly coated on the surface of the expansion stagnating block 20 is removed while forming the bonding pad bottom layer notch 602, in this way the expansion stagnating block 20 is exposed in the bonding pad bottom layer notch 602.

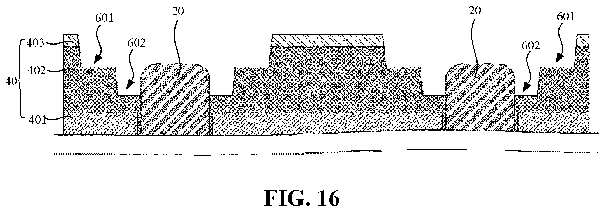

As shown in FIG. 16, part of a side wall on an end of the bonding pad bottom layer notch 602 far away from a bottom of the groove is removed to form a bonding pad top layer notch 601, the bonding pad top layer notch 601 goes through a surface of the dielectric surface layer 403 facing the bonding surface. The bonding pad top layer notch 601 may be formed through photoetching, dry etching, wet etching and other methods.

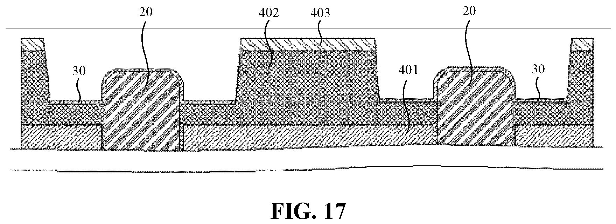

As shown in FIG. 17, in a mode of implementation that the bonding pad groove 60 is a single notch, an isolation layer 30 is formed on the expansion stagnating block 20 and a bottom of the bonding pad groove 60, respectively. Of course, the isolation layer may be formed on a side wall of the bonding pad groove 60 as well. The isolation layer 30 may be formed through deposition and other methods.

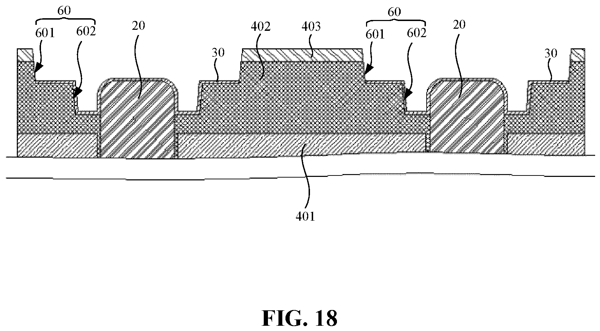

Further, in a mode of implementation that the bonding pad groove 60 may include the bonding pad bottom layer notch 602 and the bonding pad top layer notch 601, as shown in FIG. 18, the isolation layers 30 are formed on the bonding pad bottom layer notch 602, a bottom of the bonding pad top layer notch 601 and the expansion stagnating block 20. Of course, the isolation layer 30 may be formed on a side wall of the bonding pad top layer notch 601 as well. The isolation layer 30 may be formed through deposition and other methods.

Referring to FIG. 10 continuously, the method for preparing the semiconductor package structure provided by the example further includes the following operations.

At S103, a bonding pad layer is formed in the bonding pad groove.

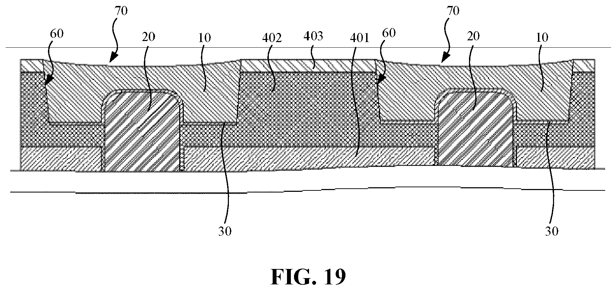

As shown in FIG. 19, in the mode of implementation that the bonding pad groove 60 is a single notch, the bonding pad layer 10 is formed in the bonding pad groove 60. The bonding pad layer 10 may be formed through deposition and other methods.

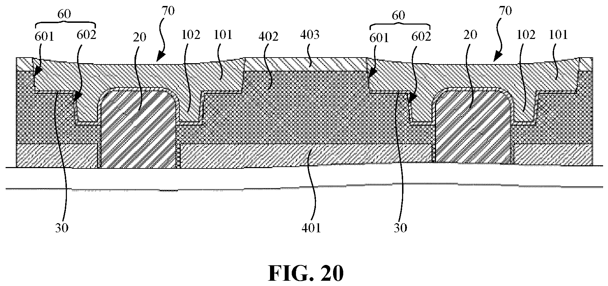

Further, as shown in FIG. 20, in the mode of implementation that the bonding pad groove 60 includes the bonding pad bottom layer notch 602 and the bonding pad top layer notch 601, the bonding pad bottom layer notch 602 is filled with a bonding pad bottom layer 102, and the bonding pad top layer notch 601 is filled with a bonding pad top layer 101 that is integrally arranged with the bonding pad bottom layer 102. The bonding pad bottom layer 102 and the bonding pad top layer 101 may be formed through deposition and other methods.

A recess 70 is formed on a surface of the bonding pad layer 10 facing the bonding surface, and the recess 70 may be formed through planarizing the surface. The planarizing may be realized by a Chemical Mechanical Polishing (CMP) process. The recess 70 is arranged to accommodate part of the expansion of the bonding pad layer 10 in a subsequent bonding process, and accordingly part of the expansion volume may be offset to a certain extent, driving force driving the semiconductor units to separate is reduced, thereby avoiding the separation between the semiconductor units.

A semiconductor device may include multiple semiconductor units that are arranged in a stacked manner, two adjacent semiconductor units are electrically connected with each other to realize signal transmission between all semiconductor units. It is noted that the semiconductor package structure prepared by the example may be a structure arranged at any semiconductor unit and for use on a connecting surface with other semiconductor units in the semiconductor device. Namely, through the method provided by the example, the connecting surface of the any semiconductor unit with the other semiconductor units in the semiconductor device may be prepared.

In a mode of implementation that the semiconductor substrate 40 is a wafer and the semiconductor structure as shown in FIG. 5 is formed on the semiconductor substrate 40, the semiconductor unit is a wafer whose both surfaces along a stacked direction are provided with the semiconductor structure as shown in FIG. 5, that is to say, both surfaces of a wafer along with a stacked direction are provided with the bonding pad groove 60, and a bonding pad layer 10 is formed in the bonding pad grooves 60. Correspondingly, one end of the expansion stagnating block 20 reaches out from the bonding pad layer 10 on one surface and extends into the corresponding bonding pad layer 10, and another end of the expansion stagnating block 20 reaches out from another surface and extends into corresponding another bonding pad layer 10. In this way, connection between the bonding pad layers 10 positioned on different surfaces of the semiconductor units may further be realized through the expansion stagnating block 20. In addition, because both the bonding pad layers 10 at two surfaces of the semiconductor units share part of the expansion stagnating block 20, the separation between the semiconductor unit and the adjacent semiconductor units can be avoided.

Operations of stacking multiple semiconductor units are as follows.

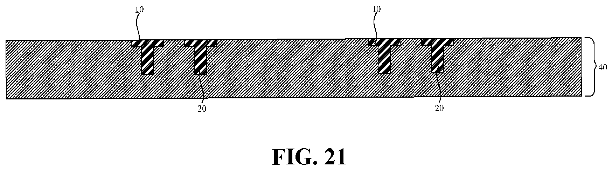

As shown in FIG. 21, the semiconductor substrate 40 is taken. One end of the semiconductor substrate is provided with the bonding pad layer 10; an expansion stagnating block 20 subjected to the high-temperature tempering is extended into the bonding pad layer 10.

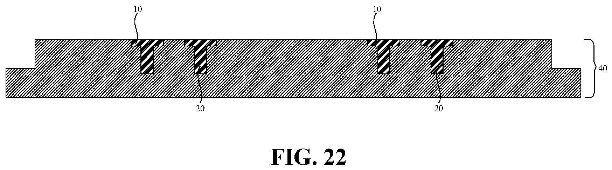

As shown in FIG. 22, an edge of the semiconductor substrate 40 is trimmed.

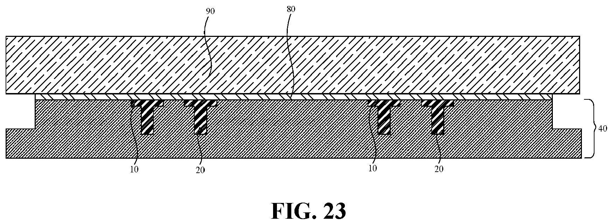

As shown in FIG. 23, one surface of the semiconductor substrate 40 exposing the bonding pad layer 10 is in connection with a transfer block 90 through an adhesion layer 80.

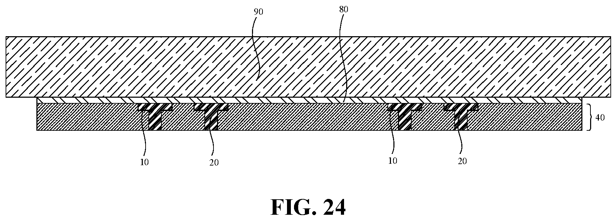

As shown in FIG. 24, the semiconductor substrate 40 is thinned, in this way one end of the expansion stagnating block 20 not extending into the bonding pad layer 10 is exposed.

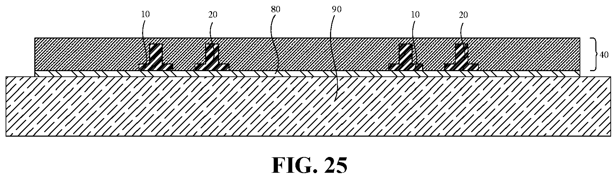

As shown in FIG. 25, the semiconductor substrate 40 is turned over along with the transfer block 90, and a dielectric layer 402 and a dielectric surface layer 403 (the dielectric layer 402 and the dielectric surface layer 403 in the figure are represented by the semiconductor substrate 40) are formed on a side of the semiconductor substrate 40 exposing the expansion stagnating block 20.

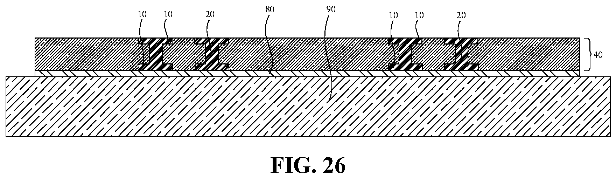

As shown in FIG. 26, a bonding pad layer 10 is formed on the side where the dielectric layer 402 and the dielectric surface layer 403 are formed, in this way both surfaces of the semiconductor substrate 40 along the stacked direction are provided with the bonding pad layer 10. Moreover, one end of the expansion stagnating block 20 extends into one of the bonding pad layer 10, and another end extends into another bonding pad layer 10, in this way the semiconductor unit is formed.

The abovementioned operations of FIG. 21 to FIG. 26 are repeated, in this way the multiple semiconductor units are formed.

Abase layer 100 is taken. The base layer 100 is a semiconductor substrate 40 whose one side is provided with a bonding pad layer 10, in this way the side of the semiconductor substrate 40 provided with the bonding pad layer 10 faces upward.

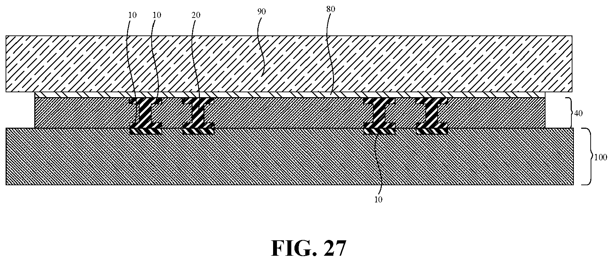

As shown in FIG. 27, a semiconductor unit is stacked on the base layer 100 by making use of the transfer block 90. It is to be noted that the bonding pad layer 10 of the semiconductor unit is aligned with the bonding pad layer 10 on the base layer 100 during stacking.

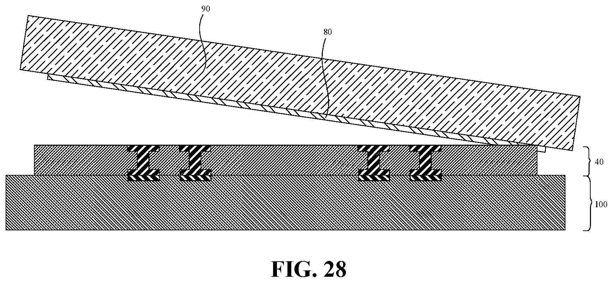

As shown in FIG. 28, the transfer block 90 is taken away to complete the stacking of a single semiconductor unit.

On the semiconductor unit, semiconductor units are continuously stacked. It is to be noted that the bonding pad layers 10 between the semiconductor units should be aligned during stacking.

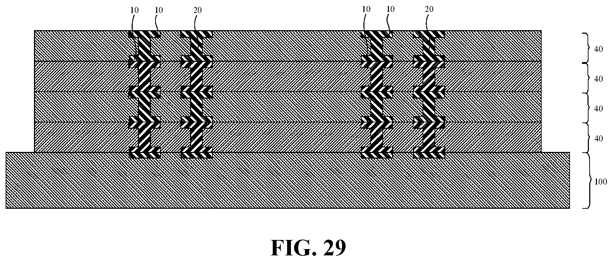

As shown in FIG. 29, the abovementioned operations of stacking are repeated to complete the stacking of the multiple semiconductor units.

It is to be finally noted that the abovementioned examples are used for describing the technical solutions of the disclosure only, rather than limiting the technical solutions of the disclosure. However the disclosure is elaborated by using the abovementioned examples for reference, it is to be understood that those of ordinary skill in the art may still modify the technical solutions recorded in the abovementioned examples, or implement equivalent replacements for part or all of the technical features. These modifications or replacements shall not make essence of the corresponding technical solutions depart from the scope of the technical solutions of all examples of the disclosure.

## Claims

1. A bonding pad structure, comprising a bonding pad layer (10) and an expansion stagnating block (20) that is at least wrapped by the bonding pad layer partially, the expansion stagnating block (20) being subjected to high-temperature tempering treatment.

2. The bonding pad structure of claim 1, wherein an isolation layer (30) is arranged between the bonding pad layer (10) and the expansion stagnating block (20).

3. The bonding pad structure of claim 1, wherein the bonding pad layer (10) comprises a bonding pad top layer (101) and a bonding pad bottom layer (102) that are arranged in a stacked manner, the bonding pad top layer (101) is arranged on a side of a bonding pad close to a bonding surface, the bonding pad bottom layer (102) and the bonding pad top layer (101) are integrated as a whole, and projection of the bonding pad bottom layer (102) on the bonding surface is positioned in projection of the bonding pad top layer (101) on the bonding surface.

4. The bonding pad structure of claim 3, wherein an area of an end of the bonding pad layer (10) close to the bonding surface is greater than an area of an end of the bonding pad layer (10) far away from the bonding surface.

5. The bonding pad structure of claim 1, wherein the bonding pad layer (10) is a metal block.

6. A semiconductor package structure comprising a semiconductor substrate (40) provided with the bonding pad structure of any one of claims 1-5.

7. The semiconductor package structure of claim 6, wherein the semiconductor substrate (40) comprises a substrate layer (401) far away from a bonding surface, and a dielectric layer (402) and a dielectric surface layer (403) that are arranged on the substrate layer (401) sequentially, the bonding pad structure being arranged on the dielectric surface layer (403) and extending into the dielectric layer (402).

8. A semiconductor structure, comprising a bonding pad layer (10) and an expansion stagnating block (20), the expansion stagnating block (20) extending into the bonding pad layer (10), and the expansion stagnating block (20) being subjected to high-temperature tempering treatment.

9. The semiconductor structure of claim 8, wherein an isolation layer (30) is arranged between the bonding pad layer (10) and the expansion stagnating block (20).

10. The semiconductor structure of claim 9, wherein the isolation layer (30) is a tantalum isolation layer or a tantalum oxide isolation layer.

11. The semiconductor structure of claim 9, wherein the bonding pad layer (10) comprises a bonding pad top layer (101) and a bonding pad bottom layer (102) that are arranged in a stacked manner, the bonding pad top layer (101) is arranged on a side of the bonding pad layer (10) close to a bonding surface, the bonding pad bottom layer (102) and the bonding pad top layer (101) are integrated as a whole, and projection of the bonding pad bottom layer (102) on the bonding surface is positioned in projection of the bonding pad top layer (101) on the bonding surface.

12. The semiconductor structure of claim 11, wherein the expansion stagnating block (20) extends into the bonding pad bottom layer (102).

13. A semiconductor package structure comprising a semiconductor substrate (40) being provided with the semiconductor structure of any one of claims 8-12.

14. A method for preparing a semiconductor package structure, comprising:
forming a semiconductor substrate in which an expansion stagnating block subjected to high-temperature tempering treatment is provided;
forming a bonding pad groove on a bonding surface of the semiconductor substrate to expose part of the expansion stagnating block; and
forming a bonding pad layer in the bonding pad groove.

15. The method of claim 14, wherein the forming a semiconductor substrate in which the expansion stagnating block subjected to high-temperature tempering treatment is provided comprises:
forming a substrate layer in which the expansion stagnating block subjected to high-temperature tempering is provided;
thinning the substrate layer so that part of the expansion stagnating block protrudes out of a surface of the substrate layer;
forming a dielectric layer on a surface of the expansion stagnating block, the dielectric layer covering the expansion stagnating block; and
planarizing a surface of the dielectric layer, and forming a dielectric surface layer on the dielectric layer.

16. The method of claim 14, wherein the semiconductor substrate is one of a chip and a wafer.

17. The method of claim 14, wherein the expansion stagnating block is a metal block, and the expansion stagnating block is formed through a Through Silicon Via process.

18. The method of claim 14, after the forming a bonding pad groove on a bonding surface of the semiconductor substrate, further comprising:
forming an isolation layer on the expansion stagnating block and a bottom of the bonding pad groove and the expansion stagnating block, respectively.

19. The method of claim 14, wherein the forming a bonding pad groove comprises:
forming a bonding pad bottom layer notch on the bonding surface of the semiconductor substrate to expose part of the expansion stagnating block;
removing part of a side wall of an end of the bonding pad bottom layer notch far away from a bottom of the groove to form the bonding pad top layer notch; and
filling a bonding pad bottom layer in the bonding pad bottom layer notch, and filling a bonding pad top layer in the bonding pad top layer notch, the bonding pad top layer being integrally arranged with the bonding pad bottom layer.

20. The method of claim 14, after the forming a bonding pad layer in the bonding pad groove, further comprising:
forming a recess on a surface of the bonding pad layer facing the bonding surface.
